Europäisches Patentamt

European Patent Office

Office européen des brevets

(19)

(11) Publication number: **0 385 799**

**A2**

(12) **EUROPEAN PATENT APPLICATION**

(21) Application number: **90302241.6**

(22) Date of filing: **02.03.90**

(51) Int. Cl.⁵: **G10L 7/00**

(30) Priority: **02.03.89 JP 50562/89**
**03.03.89 JP 51741/89**
**03.03.89 JP 51742/89**
**07.03.89 JP 54498/89**
**13.03.89 JP 60303/89**
**13.03.89 JP 60304/89**
**15.03.89 JP 63171/89**

(43) Date of publication of application:
**05.09.90 Bulletin 90/36**

(84) Designated Contracting States:
**DE GB**

(71) Applicant: **SEIKO INSTRUMENTS INC.**
**31-1, Kameido 6-chome Koto-ku**
**Tokyo 136(JP)**

(72) Inventor: **Momoshima, Yukichi**
**C/O SEIKO INSTRUMENTS INC., 31-1 Kameido**
**6-chome**
**Koto-ku, Tokyo(JP)**

(74) Representative: **Caro, William Egerton et al**
**J. MILLER & CO. Lincoln House 296-302 High**
**Holborn**
**London WC1V 7JH(GB)**

(54) **Speech signal processing method.**

(57) The invention provides a method of coding a speech signal employing adaptive differential pulse code modulation. A non-periodic part of the speech signal is coded directly by the adaptive differential pulse code modulation. A periodic part of the speech signal undergoes Fourier Transformation in synchronisation with a pitch period of the periodic part to produce spectrum data, and is then coded on the basis of the spectrum data.

FIG. 2

EP 0 385 799 A2

## SPEECH SIGNAL PROCESSING METHOD

The present invention relates to a method of processing a speech signal.

Conventionally ADPCM (referring to adaptive differential pulse code modulation) is generally used for digital coding of a speech signal. Such a technique is disclosed, for example, in Japanese Laid Open Patent Application No. 148716/1988. However, the conventional ADPCM coding only achieves a data compaction rate of about 50%. Therefore, when carrying out recording/reproducing of speech using a solid memory device, a considerable capacity is still needed.

The present invention addresses the problem of providing a coding method for a speech signal effective to increase the data compaction rate without complicating the processing of the speech signal.

According to the present invention, there is provided a method of coding a speech signal employing adaptive differential pulse code modulation, characterised by the steps of coding a non-periodic part of the speech signal by the adaptive differential pulse code modulation, effecting a Fourier transform for a periodic part of the speech signal in synchronisation with a pitch period of the periodic part to produce spectrum data, and coding the periodic part based on the spectrum data.

More particularly, in order to code a speech signal with a number of bits as small as possible, two different kinds of coding are selectively carried out throughout the speech signal. The first kind of coding is based on direct adaptive differential pulse code modulation for a waveform of the speech signal and the second kind of coding is based on spectrum data obtained by effecting Fourier Transformation of the speech signal in synchronisation with a pitch of the speech signal so as to achieve high data compaction.

The present invention has a number of aspects, and it also relates specifically to a method of processing a speech signal to determine a transition timing when the speech signal switches from a state of silence to a state of utterance. The present invention further relates specifically to a method of detecting a pitch period of a periodic part contained in a speech signal.

When conventionally recording an input speech signal, the analog speech signal is coded into digital data in various ways to carry out efficient recording of the speech. In such a case, it has been suggested that a silence part contained in a speech signal could be represented by data indicative of time duration of the silence part with a reduced number of data bits. When carrying out such coding for a silence part, it is especially important to detect a transistion timing when the silence part is terminated and the signal switches to an utterance part. This transition timing could simply be detected by monitoring when the level of a speech signal exceeds a given reference level. When the level of the speech signal exceeds the given reference level, the coding of the utterance part may be initiated to achieve data compaction. However, in such a simple method, the coding of an utterance part would frequently be inadvertently initiated in response to level fluctuation due to noise. Thus, a silence part would be coded like an utterance part thereby wasting memory capacity.

The present invention at least in its preferred form, therefore, also addresses the problem of processing a speech signal so as accurately to detect transition timing from a silence part to an utterance part in the speech signal.

According to a second aspect of the invention, after an amplitude or level of the speech signal exceeds the first reference level, when the amplitude further exceeds a second reference level higher than the first reference level within a pre-determined time interval, a judgement is made that the speech signal has switched from a state of silence to a state of utterance at the time when the speech signal exceeded the first reference level.

It is also advisable to detect a pitch period of a periodic part of the speech signal for efficiently coding that part. In such a case, conventionally, zero-cross point data of the speech signal is produced and its sequential arrangement along a time axis is analysed to find a pitch period of the periodic part. However, in the conventional method, in order to find regularity in the zero-cross point data sequence, a complicated program including conditional judgement steps has to be executed by a computer, thereby causing drawbacks such as difficulties in responsive coding of the speech signal in real time basis due to delay of pitch period detection.

The present invention, at least in its preferred form, therefore, addresses the problem of detecting a pitch period quickly and accurately for a periodic part of a speech signal according to a simplified program.

According to a third aspect of the invention, in order to detect a pitch period of a periodic part in a speech signal, signal processing is carried out to find a first peak in a given segment of a speech signal waveform and to find a corresponding second peak in a given time interval beyond a blank time slot, which is determined according to the level of the first peak, so as to determine the pitch period.

Further, according to the third aspect of the present invention, processing of a speech signal is carried

2

out to detect a first peak within a given time interval. Then, a second peak corresponding to the first peak is detected by checking the speech signal level after a check starting moment, which is determined according to the level of the first peak. Further, a judgement is made as to whether a subsequent peak occurs at a pitch period, which is determined according to the first and second peaks, so as to confirm the correctness of the determined pitch period to ensure the accurate detection of the speech signal pitch.

The conventional ADPCM coding does not have a high data compaction rate. In order to increase the data compaction rate, it is proposed to switch coding mode according to the state of a speech signal such that a non-periodic part thereof is coded directly as it is on time axis basis according to ADPCM and a periodic part is first converted into spectrum data on frequency axis basis and then coded according to ADPCM. When coding the speech signal by switching between the two kinds of coding modes, in order to realise smooth switching, at the initiation of ADPCM coding based on the frequency spectrum data, one pitch segment of the speech signal may be directly and temporarily stored in the memory in the form of spectrum data so as to provide initialisation data. This stored initialisation data is not subject to any compaction treatment. Therefore, non-compaction data is generated every time the coding mode is switched, thereby causing the problem that the overall data compaction rate may be lowered.

The invention at least in its preferred form, therefore, also addresses the problem of coding speech signal effective to avoid a reduction of the overall data compaction rate when executing the coding by switching between two kinds of data coding processes.

According to a fourth aspect of the present invention, when coding a speech signal according to ADPCM, a first pitch segment of the speech signal waveform is coded directly on time axis basis according to ADPCM. Thereafter, a subsequent pitch segment is converted from the time axis basis into frequency axis basis to obtain corresponding frequency spectrum data. Then, the frequency spectrum data is coded according to ADPCM differentially using coded data of the first pitch segment as initial data.

The fourth aspect of the present invention further seeks to code a periodic part of the speech signal according to a specific high data compaction coding method utilising a periodic nature of the speech signal. When the periodic part is followed by an utterance part which has a time duration shorter than one pitch period of the periodic part, this utterance part is also coded according to the specific high data compaction coding method.

However, in such a coding method, since the different coding modes are alternately switched, it is desirable to avoid dis-continuation or irregulatiry in reproduction of the speech signal due to the switching of the coding modes.

The present invention at least in its preferred form, therefore, seeks to provide a speech signal coding method effective to avoid drawbacks when reproducing a speech signal coded by switching between different coding modes so as to achieve more accurate and natural reproduction of the coded speech signal.

A fifth aspect of the present invention concerns the coding differently of a periodic part and a non-periodic part of the speech signal to achieve high data compaction rate. The non-periodic part is coded utilising particular initial data, which is obtained by de-coding frequency spectrum data of a last pitch segment of a periodic part immediately preceding the non-periodic part.

The invention will be described further, by way of example, with reference to the accompanying drawings, in which:-

Figure 1 is a block diagram showing one form of apparatus for processing a speech signal according to the present invention;

Figure 2 is a flow chart representing overall processing of a speech signal according to the present invention;

Figure 3 is a diagram of a speech signal waveform for illustrating the processing steps of Figure 2;

Figure 4 is a flow chart representing utterance discrimination in the processing method according to the present invention;

Figure 5 is a diagram of a speech signal waveform for illustrating the processing steps of Figure 4;

Figure 6 is a flow chart representing processing to detect pitch period in the processing method according to the present invention;

Figure 7 is a diagram of a speech signal waveform for illustrating the processing steps of Figure 6;

Figure 8 is a flow chart representing a first procedure in the processing steps of Figure 6;

Figure 9 is a flow chart representing a second procedure in the processing steps of Figure 6;

Figure 10 is a detail of the speech signal waveform of Figure 7 for illustrating the processing steps in the second procedure;

Figure 11 is a flow chart representing a third procedure in the processing steps of Figure 6;

Figure 12 is a diagram of another speech signal waveform to be coded by a modified processing method according to the present invention; and

Figure 13 is a flow chart representing modified overall processing of a speech signal according to the present invention.

## Overall processing

The processing method according to the present invention is characterised in that coding of a speech signal is effected by ADPCM (adaptive differential pulse code modulation) for parts of the speech signal, in which a pitch period cannot be detected, while coding is effected for other parts of the speech signal, in which a pitch period can be detected, based on spectrum data for such other parts obtained by Fourier Transformation in synchronisation with the detected pitch period, whereby high data compaction rate in the coding may be achieved.

The coding is effected by direct ADPCM for parts of the waveform of the speech signal representative of consonants, for example, for which a pitch period cannot be recognised. On the other hand, for other parts of the waveform of the speech signal represen tative of vowels, for example, having a detectable pitch period, the coding is effected according to spectrum data produced by Fourier Transformation of these parts in synchronisation with the pitch period. Consequently, the data compaction rate can be greatly increased in relation to the parts having a detectable pitch period, thereby enabling overall data compaction in the digital coding of an analog speech signal.

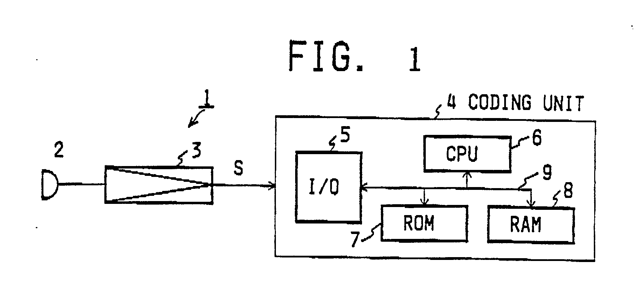

The overall processing of a speech signal according to the present invention is described in detail with reference to Figures 1 to 3. Figure 1 shows one embodiment of apparatus 1 for coding a speech signal according to the present invention. The apparatus 1 comprises a microphone 2 for converting speech into a corresponding analog speech signal, and an amplifier 3 for amplifying the signal from the microphone 2 to produce an output for supply to a coding unit 4 as a speech signal S to be coded. The coding unit 4 comprises a micro-computer, which includes an I/O interface 5, a CPU 6, a ROM 7, a RAM 8 and a data bus 9. According to a coding program provisionally stored in the ROM 7, the speech signal S is efficiently coded into digital data which is stored in the RAM 8.

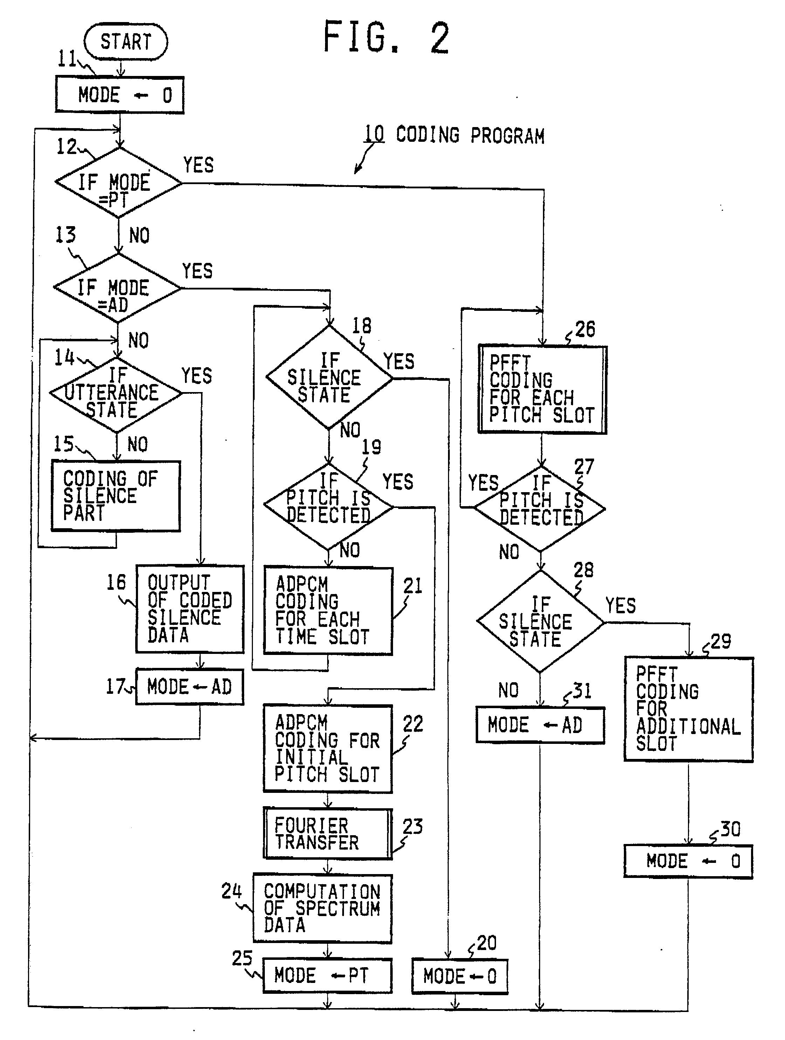

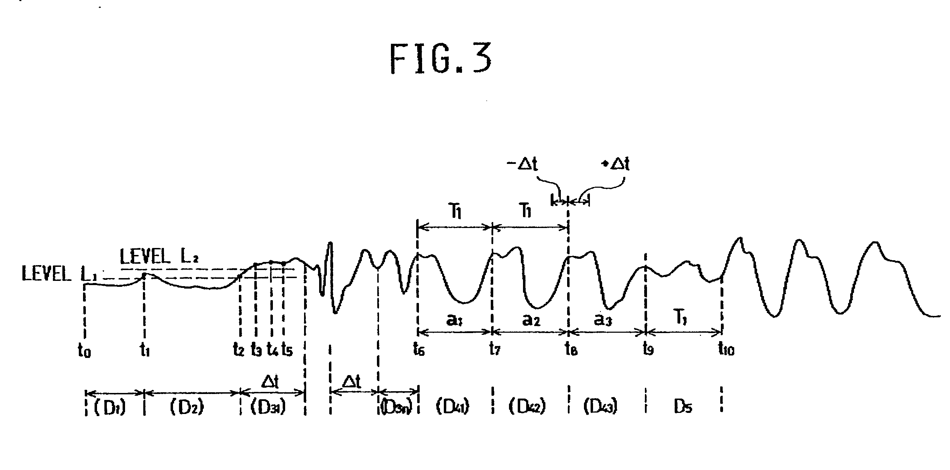

Figure 2 is a flow chart representing a coding program 10 stored in the ROM 7. Hereinafter, a description is given of the coding of a speech signal S as indicated in Figure 3 by means of the steps illustrated in the flow chart of Figure 2.

When starting to execute the coding program 10, in step 11, mode data MODE, which indicates a mode of coding, is set to the value 0. MODE = 0 indicates a silence coding mode for coding a part of the speech signal S representing silence. In the next step 12, a judgement is made as to whether the mode data MODE is set to PT, which represents a coding mode based on pitch period Fourier Transformation (hereinafter, referred to as the "PT coding mode"). At this point, since MODE = 0, the result is a negative or NO in the step 12 and the processing proceeds to step 13. In the step 13, a judgement is made as to whether the mode data MODE is set to AD, which is indicative of the ADPCM coding. Since MODE = 0, the judgement is NO and the processing proceeds to step 14.

In the step 14, the amplitude or level $L_{in}$ of the input speech signal S is compared with a first pre-determined reference level $L_1$ to discriminate between a state of utterance and a state of silence in the speech signal S. If $L_{in} < L_1$, the state of silence is assumed so that the judgement is NO in the step 14 and the processing proceeds to step 15. In this step, the input speech signal S is digitally coded according to the silence coding mode. The silence coding mode is executed in the step 15 such that the passage of time is cumulatively counted by a suitable digital counter from an initial point $t_0$ (see Figure 3) of the coding process. The steps 14 and 15 are carried out repeatedly at each sampling time until the level $L_{in}$ of the speech signal reaches the first reference level $L_1$ at the time $t = t_1$. When $L_{in} \geq L_1$ at the time $t = t_1$, the judgement becomes affirmative or YES in the step 14 and the processing thereby proceeds to step 16. In this step, silence code data $D_1$ representative of the silence time slot $t_1 - t_0$ to is output and is stored in a given address of the RAM 8. Thereafter, in step 17 the mode data MODE is re-set to AD, and the processing is returned to the step 12.

This time, the judgement remains NO in the step 12 and the subsequent judgement is changed to YES in the step 13 and the processing thereby proceeds to step 18. In this step, a judgement is made as to whether the amplitude or level $L_{in}$ exceeds a second pre-determined reference level $L_2$, set greater than the first reference level $L_1$, on three sequential occasions at succeeding sampling times. If on the three successive sampling times the speech signal level exceeds the level $L_2$, it is held that the state of silence is terminated. Accordingly, the judgement in the step 18 is NO and the processing proceeds to step 19. On

4

the other hand, if the state of silence still continues according to the above noted discrimination process, the judgement in this step is YES and the mode data MODE is re-set to 0 in step 20 and the processing thereby returns to the step 12.

For example, in the case of the Figure 3 waveform, since $L_{in} < L_2$ at time $t = t_1$, the judgement is YES in the step 18 thereby returning the processing again to carry out repeatedly the processing in the steps 14 and 15. Then, when $L_{in} > L_1$ again at time $t = t_2$, the next silence code data $D_2$ indicative of a second silence time slot $t_2 - t_1$ is output from the digital counter and is stored in a given address of the RAM 8. Thereafter, the step 18 is again carried out to determine whether the state of silence has terminated. As shown in Figure 3, the level $L_{in}$ of the speech signal S exceeds the second reference level $L_2$ at three successive sampling times $t_3$, $t_4$ and $t_5$ following the time $t_2$ so that the judgement is NO in the step 18 and the processing proceeds to the step 19 so as to effect coding of a part of the speech signal representing utterance.

As described above, two different reference levels $L_1$ and $L_2$ are utilised to discriminate between the silence part and the utterance part in the speech signal. Thus, when $L_{in} > L_1$ is an incidental occurrence due to noise, the coding for the utterance part will not be initiated. Therefore, the silence part of the speech signal can be coded accurately with a short amount of digital data, thereby contributing greatly to data compaction. The judgement made in the step 18 is based on the condition $L_{in} > L_2$ occurring continuously three times. However, the number of such occurrences and other parameters may be suitably set depending on features of speech signals.

In the step 19, processing is carried out to detect a pitch period of the speech signal S. If the pitch period cannot be detected, processing proceeds to step 21 so as to effect ADPCM coding for each pre-determined time interval $\Delta t$. For example in the Figure 3 waveform, some consonant is being uttered in the time slot from $t_2$ to $t_6$ so that the direct ADPCM coding is carried out for the analog waveform in this time slot. Namely, a judgement is made in the step 19 that a pitch period cannot be detected, and so ADPCM coding is carried out for a segment of the waveform S in the time interval $\Delta t$ measured from the time $t_2$ to produce digital data $D_{31}$, which is stored in the RAM 8, and then the processing returns to the step 18. This ADPCM coding is repeatedly carried out n times for each successive time interval $\Delta t$ to produce corresponding digital data $D_{32}$, ..., $D_{3n}$.

Then, after time $t_6$, some vowel is uttered so that a pitch period $T_1$ is detected in the step 19 whereby the processing proceeds to step 22. In this step, the ADPCM coding is carried out for a waveform segment in a first pitch slot $a_1$ during the detected pitch period $t_1$ to produce corresponding code data $D_{41}$, which is stored in the RAM 8, and then the processing proceeds to step 23. In this step 23, the waveform segment of the speech signal S within the first pitch slot $a_1$ is subjected to Fourier Transformation, and its spectrum data is computed in step 24. Then, the coding mode data MODE is set to PT in step 25, and thereafter processing returns to the step 12.

Consequently, at this time, the judgement in the step 12 becomes YES so as to effect coding of a periodic part of the speech signal according to the PT coding mode. Firstly, in step 26, the spectrum data computed in the step 24 for the first pitch slot $a_1$ is stored temporarily in the RAM 8 as initial data.

Next, processing is carried out in step 27 to confirm a next pitch slot $a_2$. In this stage, processing of the speech signal is effected to detect a next peak of the waveform occurring from the time $t = t_7$ as a starting point and, using the pitch period $T_1$ as a reference, within a time range $t_7 + T_1 \pm \Delta T$ where the value of $\Delta T$ will be suitably set. Consequently, a time $t_8$ as an end point is determined according to the detection of the next peak in that range thereby setting the next pitch slot $a_2$. Then, returning to the step 26, the second waveform segment within the second pitch slot $a_2$ is analysed to compute a corresponding second spectrum data therefor. Further, this second spectrum data obtained in the second pitch slot $a_2$ is compared to the initial spectrum data obtained in the first pitch slot $a_1$, to compute differential data therebetween. ADPCM coding is effected for this differential spectrum data to produce second code data $D_{42}$, which is stored in the RAM 8. Concurrently, the initial·spectrum data is up-dated to or replaced by the second spectrum data. The sequential processing in the step 26 is hereinafter referred to as "PFFT coding". The steps 26 and 27 are repeatedly carried out to effect PFFT coding every time a successive peak of the waveform is detected with reference to the pitch period $T_1$ whereby to produce code data $D_{43}$, ..., $D_{4n}$ by sequentially comparing the preceding spectrum data and the succeeding spectrum data with each other.

In Figure 3, the waveform segment in the third pitch slot $a_3$ is followed by a non-periodic part of the waveform, so that the judgement in the step 27 changes to NO whereby processing proceeds to step 28.

In the step 28, a check is effected as to whether the level of the waveform is below a pre-determined value at the time $t = t_9 + T_1 = t_{10}$ so as to ascertain if a silence part follows. When the level or amplitude of the speech signal S is below the pre-determined level at the time $t_{10}$, the judgement is YES and

5

processing proceeds to step 29. In this step, digital coding is carried out according to the PT coding mode for the time slot between $t_9$ and $t_{10}$ to produce last code data $D_5$, which is stored in the RAM 8. Then, the coding mode data MODE is set to 0 in step 30 and processing returns to the step 12.

On the other hand, if the judgement in the step 28 is that a silence part does not exist, processing advances to step 31 to set MODE = AD and return to the step 12. In the Figure 3 waveform, the level thereof exceeds the pre-determined level at time $t_{10}$ so that the ADPCM coding mode is selected and processing proceeds to the step 18 through the steps 12 and 13.

In the Figure 3 waveform, the speech signal S changes periodically after the time $t_{10}$, and hence another pitch period $T_2$ is detected in the step 19. Therefore, coding is again carried out in a manner similar to that effected between time $t_6$ and time $t_9$.

As described above, the silence part can be accurately detected and its time duration measured, the measured value being stored as the coded digital data for the silence part.

Further, the non-periodic part of the speech signal is coded directly according to the ADPCM. On the other hand, in the periodic part, during which some vowel may be being uttered, a pitch is detected and each waveform segment in each pitch period is subjected to Fourier Transformation to produce corresponding spectrum data. The respective spectrum data is then processed and coded according to ADPCM. In this processing, succeeding spectrum data is compared with preceding spectrum data and the differential data is coded according to ADPCM so as to achieve further data compaction.

The present invention has been described with reference to the Figure 2 flow chart and the Figure 3 speech signal waveform. However, the method can be applied to various speech signal waveforms other than the Figure 3 waveform to effect high data compaction and, therefore, the invention is not limited to the above described embodiment.

As described above, according to the present invention, the spectrum conversion and subsequent ADPCM coding are applied to a periodic part of a speech signal to achieve high data compaction coding in such part and thereby realise overall coding of the speech signal with a high compaction rate.

## Processing for discriminating between silence and utterance

As described, the method of processing a speech signal so as to determine the timing in the speech signal when a state of silence switches to a state of utterance comprises a first step of detecting when an amplitude of the speech signal exceeds a first pre-determined reference level, a second step of detecting when the amplitude of the speech signal exceeds a second pre-determined reference level, which is set to be greater than the first reference level, and a third step of responding to the detection results in the first and second steps by assuming that the state of utterance occurred from the timing at which the amplitude exceeded the first reference level, when the amplitude exceeds the second reference level within a pre-determined time interval from that timing.

When a level of the speech signal rises momentarily due to noise during a state of continuous silence, there is a very slight probability that the level of the speech signal will rise further to exceed the second reference level within a short time interval. Therefore, the final judgement as to whether the speech signal has switched to an utterance part is not made at the time when the level of the speech signal merely exceeds the first reference level.

On the other hand, when the level of the speech signal exceeds the second reference level within a reasonable time interval after the level of the speech signal has exceeded the first reference level, a firm judgement that the speech signal changed to an utterance part at the time when the amplitude of the speech exceeded the first reference level is made. Then, the coding of the utterance part may be carried out for segments of the waveform of the speech signal in respective time slots after the amplitude exceeded the first reference level.

Such processing is described below in detail with reference to Figures 1, 4 and 5 of the drawings. The coding arrangement for determining the transition timing from a silence part to an utterance part in a speech signal according to the invention and for coding the speech signal based on this determination is included in the apparatus of Figure 1. The coding arrangement includes the coding unit 4 for coding the analog speech signal S which is fed through the amplifier 3 from the microphone 2. The coding unit 4 includes the micro-computer which comprises the I/O interface 5, CPU 6, ROM 7, RAM 8 and data bus 9. A signal processing program effective to discriminate between a silence part and an utterance part in the speech signal S and to effect coding of the respective parts is provisionally stored in the ROM 7. The RAM 8 is arranged to store digital code data obtained according to the signal processing.

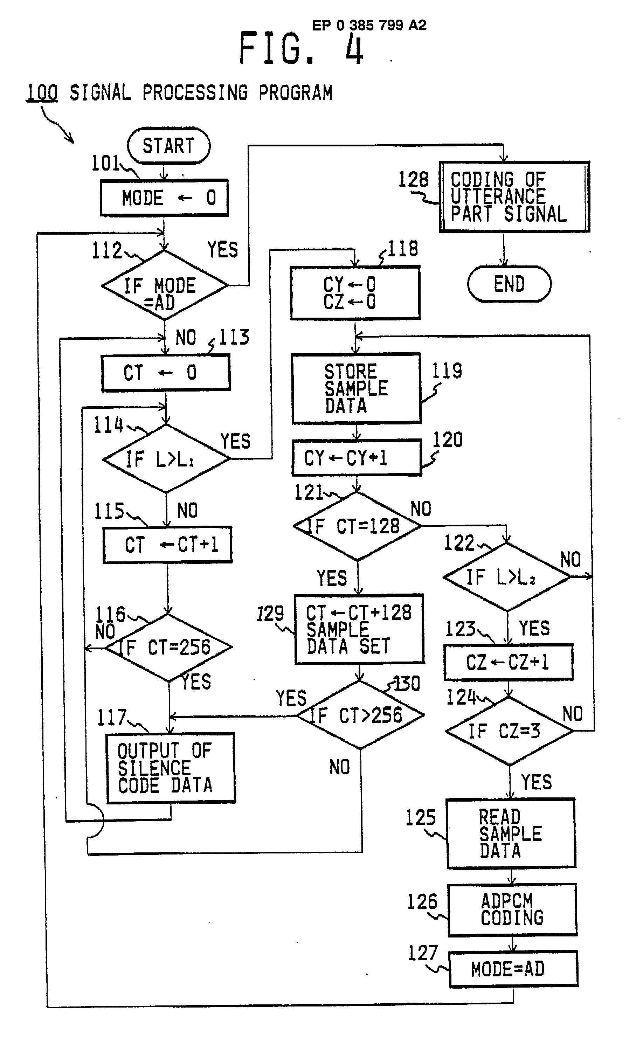

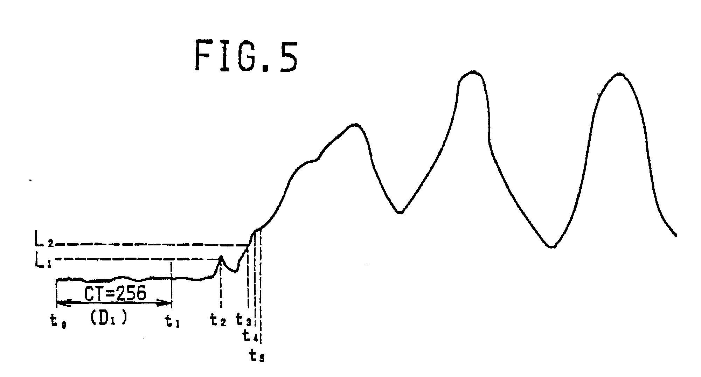

The discrimination procedure is described for coding a speech signal S whose waveform is shown in Figure 5 according to a signal processing program 100 represented by the flow chart in Figure 4. When starting to execute the signal processing program 100, mode data MODE indicative of the coding mode is set to 0 in step 101. The mode data MODE = 0, as mentioned, indicates the silence coding mode effective to code the speech signal in the state of silence. The silence coding mode is carried out to determine the time duration of the silence part.

In the next step 112, a judgement is made as to whether the mode data MODE is set to AD indicative of the ADPCM mode, which can be applied to coding of an utterance part. At this point, since the mode data MODE has initially been set to 0, the judgement is NO in the step 112 and the processing proceeds to step 113. Thereafter, signal processing is carried out to detect the transition timing from a silence part to an utterance part and to code the silence part.

A counter value CT is set to zero in the step 113. Then, a judgement is made in step 114 as to whether the amplitude or level L of the speech signal S exceeds the first pre-determined level $L_1$ according to current sample data of the speech signal S. If $L \leq L_1$, the judgement is NO in the step 114. Then, the counter value CT is incremented by the integer value 1 in step 115. Next, a judgement is made in step 116 as to whether the counter value CT has reached a final number 256. If $CT \neq 256$, the processing returns to the step 114, thereby carrying out repeatedly the steps 114, 115 and 116. When the counter value CT reaches the number 256 while L never exceeds $L_1$, the judgement in the step 116 changes to YES and silence code data $D_1$ is produced in step 117 and stored in the RAM 8. The silence code data $D_1$ represents a time interval from starting the execution of the program, corresponding to the value CT = 256. Therefore, the content 256 of the counter can be output as the data $D_1$. When the silence code data $D_1$ is output in the step 117, the procedure returns to the step 113, in which the counter value CT is re-set to zero and the above processing is repeated for a second cycle.

Referring to the Figure 5 waveform, when the level L exceeds the first reference level $L_1$ at a time t = $t_2$ and before the content of the counter reaches the number 256 in the second cycle, the judgement is YES in the step 114 whereby processing proceeds to step 118. In this step, other counters having values CY and CZ are respectively re-set to zero. In the next step 119, sample data of the speech signal S is successively stored after the time t = $t_2$, while the counter value CY is correspondingly incremented in step 120. Then, a judgement is made in step 121 as to whether the counter value CY has reached the number 128. Namely, a judgement is effected to determine the passage of a pre-determined time interval or window as counted by the counter having the value CY.

While that pre-determined time interval has not lapsed, i.e while the counter value CY has not reached the final value 128, the judgement is NO in the step 121. Meanwhile, a judgement is successively carried out in step 122 as to whether the level L of the speech signal exceeds the second reference level $L_2$. As shown in Figure 5, the second reference level $L_2$ is set to be moderately greater than the first reference level $L_1$.

Every time when the sampled signal level L exceeds the second reference level $L_2$, the counter value CZ is incremented by the integer value 1 in step 123. Then, a judgement is made in step 124 as to whether the value CZ = 3. At this stage, since the value CZ = 1, the judgement is NO in the step 124 and the processing returns to the step 119. The same processing is undertaken in the case of $L \leq L_2$.

As shown in Figure 5, after the sampled signal level L exceeds the first reference level $L_1$ at the time t = $t_2$ and before the counter value CY reaches the final number 128, if the sampled signal level L exceeds the second reference level $L_2$ three times, the judgement changes to YES in the step 124. Then, a set of the stored sample data is read out in step 125. The set of the sample data has been stored in the step 119 after the time t = $t_2$, and the set represents a segment of the waveform in the time slot $t_5$ - $t_2$. Namely, since the condition $L > L_2$ has occurred three times within the pre-determined time interval or window defined by the last number 128 of the counter value CY, after the sampled signal level L has exceeded the first reference level $L_1$, the firm judgement is made that the speech signal has turned into a state of utterance from the time t = $t_2$. The sample data taken in the time slot $t_5$ - $t_2$ represents a segment of the utterance part of the waveform in that time slot, and is coded according to ADPCM in step 126. Thereafter, the mode data MODE is set to AD in step 127, whereby processing returns to the step 112. The speech signal S after the time t = $t_5$ is coded according to ADPCM in step 128.

On the other hand, after the sample signal level L has exceeded the first reference level $L_1$ at the time $t_2$, if the condition $L \geq L_2$ does not occur three times while the counter whose value is CY counts up to 128, the alternative judgement is made that the rising of the signal level at the time $t_2$ is of a temporary nature due to noise etc. Then, in step 129, the number 128 is added to the counter value CT within the time slot $t_2$ = $t_1$. A judgement as to whether the thus obtained sum exceeds the number 256 is made in step 130. If it does, and the judgement is YES in the step 130, the sum data is output as the silence code data in step

7

117. On the other hand, if the sum is less than the number 256, the step 130 is followed by the step 114 for further detecting when the sampled signal level L exceeds the first reference level $L_1$ in the continued second cycle.

In the described embodiment, a firm judgement is made that the state of utterance has occurred at the time that $L > L_1$ when the sampled signal level has exceeded the second reference level $L_2$ three times while the counter having the value CY is counting to the number 128 after the time when $L > L_1$. However, such a judgement condition can be appropriately set depending on the nature of the speech signal. For example, the condition may be set on the basis that the state of $L > L_2$ occurs continuously several times or that the state of $L > L_2$ occurs at least once. Further, the first and second reference levels $L_1$ and $L_2$ may be appropriately determined.

As described above, according to a second aspect of the present invention, if the sampled signal level exceeds the first reference level, checking is carried out as to whether the subsequently sampled signal level exceeds the second reference level set moderately higher than the first reference level. Based on this checking, a decision is made as to when the speech signal turns to a state of utterance. Therefore, the state of utterance can be quickly and accurately detected to facilitate the signal processing of the utterance part. Thus, mis-coding can be effectively avoided, in contrast to the prior art in which the discrimination of an utterance part is carried out simply by monitoring a sampled signal level with respect to a single reference level.

## Processing for detecting pitch period

The method of detecting the pitch period in a periodic part of the speech signal comprises a first step of detecting a first timing when a level of the speech signal reaches a maximum peak value within a given time interval, a second step of setting a blank time slot according to the maximum peak value, a third step of detecting a second timing when the level of the speech signal reaches another maximum peak value within another given time interval after the passage of the blank time slot, and a fourth step of checking whether a time duration between the first and second timings appropriately indicates the pitch period of the speech signal.

If a subsequent maximum peak exists at a subsequent time $t_1$ following a first time $t_0$ at which the first maximum peak is detected in the first step, such subsequent peak will be detected in a time interval beyond the blank time slot by the third step. In order to confirm that the detected subsequent peak periodically corresponds with the first peak, checking is carried out as to whether a third peak exists at a window time slot which is set after the time $t_1$ by an interval of $| t_1 - t_0 |$. By such a procedure, the pitch period in the periodic part of the speech signal is detected and confirmed.

Hereinafter, this procedure will be described in detail with reference to Figures 1 and 6 to 11. The signal processing arrangement for detecting a pitch period of a periodic part in a speech signal according to the invention is included in the apparatus of Figure 1. The signal processing arrangement includes the microphone 2 for converting speech into the corresponding analog signal, the amplifier 3 for amplifying the signal from the microphone 2, and the coding unit 4 including a pitch detector for receiving the speech signal S from the amplifier 3.

The pitch detector is provided by the micro- computer comprising the I/O interface 5, CPU 6, ROM 7, RAM 8 and data bus 9. A processing program effective to detect a pitch is provisionally stored in the ROM 7. The speech signal S is processed according to the program to find a pitch period.

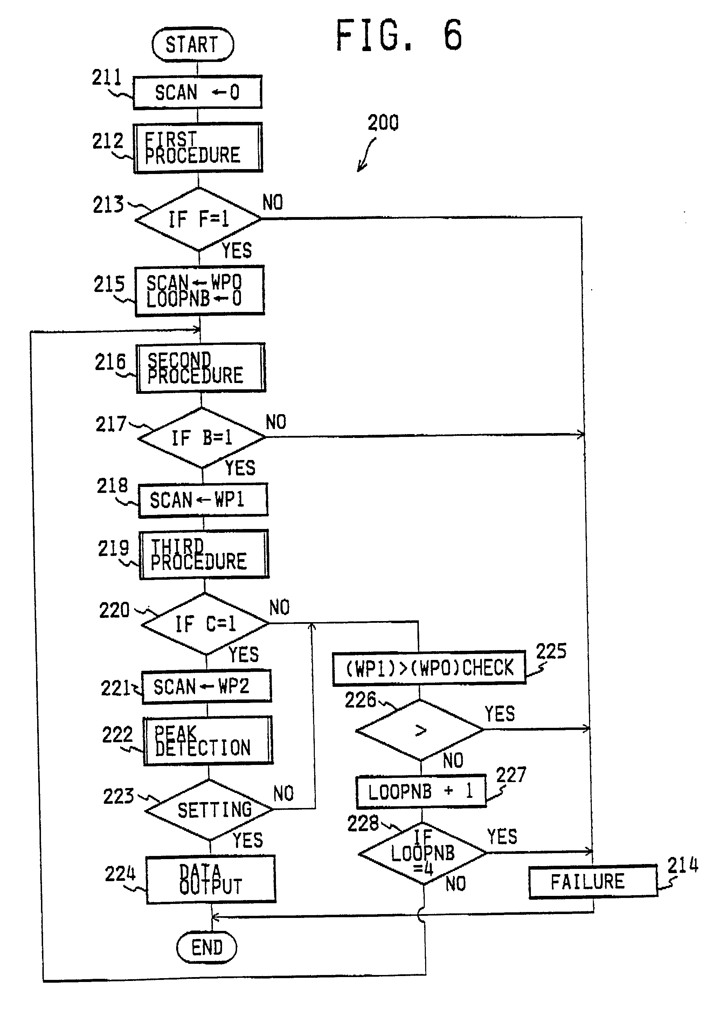

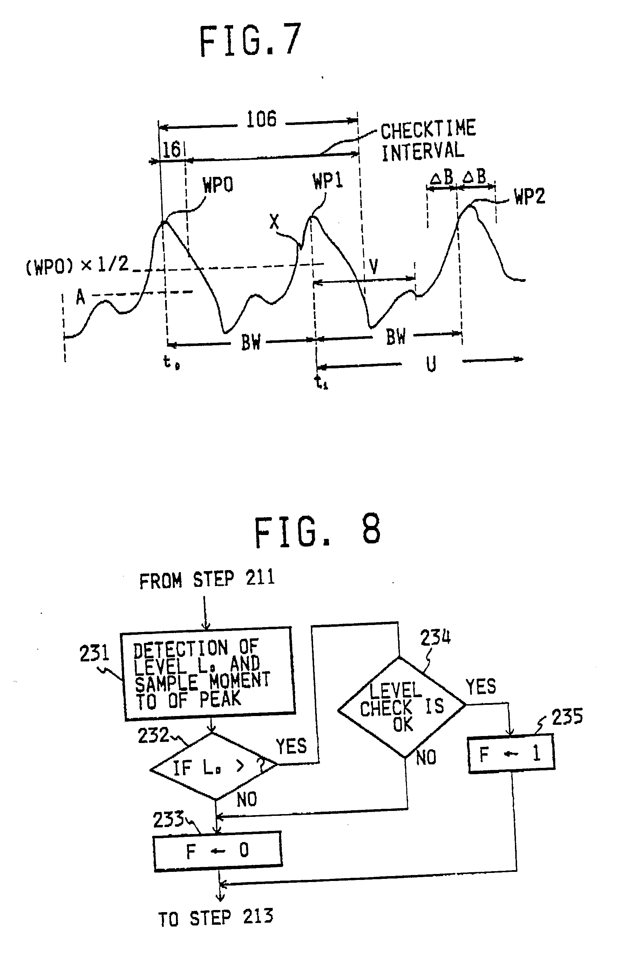

Figure 6 is a flow chart representing a pitch detection process program 200. Hereinafter, the method of detecting a pitch period for a speech signal S whose waveform is shown in Figure 7 will be described with reference to the Figure 6 flow chart. In step 211, an origin time point on the time axis is set as a detection reference point SCAN. In the next step 212, a first procedure is carried out to detect a maximum peak point WP0 within a pre-determined time interval which contains a number 64 of sampling moments.

Details of the first procedure are indicated in a flow chart shown in Figure 8. In step 231, signal processing is carried out to identify both a particular sample among the set of 64 data samples, which has the maximum amplitude level $L_0$, and a particular moment or time $t_0$ at which the particular sample was taken. In step 232, a judgement is made as to whether the level $L_0$ exceeds a pre-determined level A. Preferably, the level A is set to be about one half of the peak level of the speech signal S. This comparison is effectively to preclude inadvertent detection in the case that the detected maximum level $L_0$ represents noise at a lower level.

If $L_0 \leq A$, a flag F is cleared in step 233, the processing thereafter proceeding to step 213 of Figure 6. If

8

$L_0 > A$, a subsequent judgement is made in step 234 as to whether the levels of two data samples subsequent to the maximum data sample at the time $t_0$ still exceed the level A. When the maximum data sample at the time $t_0$ is not of a momentary or pulsive nature, the three sequential data samples all exceed the level A generally.

When the level checking is held good in step 234, the flag F is set to the value 1 in step 235, and processing proceeds to the step 213 of Figure 6. If the level checking is held not good in the step 234, the flag F is cleared in the step 233, whereafter processing proceeds to step 213. The flag F is indicative of whether appropriate maximum peak data is contained in the first set of 64 data samples. If F = 0, a judgement NO is made in the step 214 of Figure 6, whereby the pitch detector outputs a signal indicative of failure of pitch detection. On the other hand, when the first peak is detected in the step 212, the flag F is set to the value 1, and then processing proceeds to step 215 of Figure 6.

In the step 215, the detection reference point SCAN is up-dated to WP0 indicative of the first peak at the time $t_0$, and the content LOOPNB of a loop counter is set to zero. Thereafter, a second procedure is carried out in step 216 to detect a second peak WP1 subsequent to and corresponding with the first peak WP0.

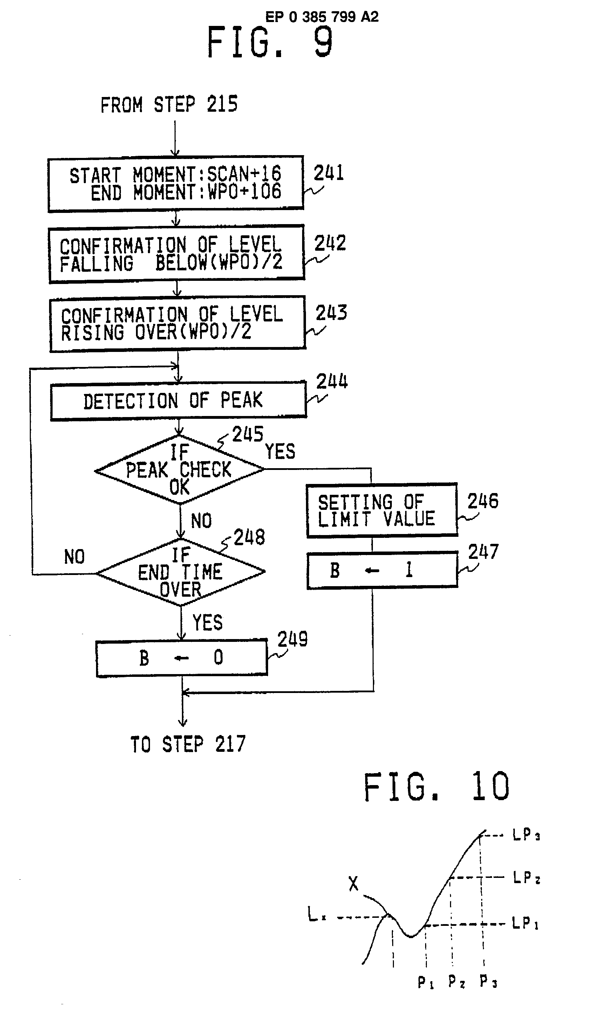

A detailed description of the second procedure is given with reference to Figure 9. Firstly, in step 241, a level check interval is set for the speech signal. In this embodiment, the level check is carried out within a check time interval from SCAN + 16 to SCAN + 106, i.e. from the sixteenth sampling moment after the time $t_0$ to the 106th sampling moment. The check time interval is appropriately determined according to the level of the peak WP0, for example, so as to carry out an efficient check operation.

In step 242, confirmation is made as to when the level of the speech signal falls below a level which is half of the peak level (WP0) of the first peak WP0. Further, in step 243, confirmation is made as to when the level of the speech signal again rises above the level which is half of the peak level (WP0). In the present instance, it is assumed that no peak corresponding to the first peak WP0 appears in a blank time slot determined according to the peak level (WP0), i.e. in the time slot from the time $t_0$ to the moment when the speech signal again rises above the level half (WP0). Based on this assumption, after the confirmation in the step 243, processing is initiated in step 244 to detect another peak.

Namely, as shown in Figure 7, in order to detect the next peak WP1 based on sample data obtained after the blank slot, first of all a peak X is detected, which occurs initially after the blank time slot and which has a peak level $L_x$. A check is carried out in step 245 as to whether the detected peak X corresponds to an expected next peak WP1. As shown in Figure 10, this check is effected in that a plurality (for example three) of successive speech signal levels $LP_1$, $LP_2$ and $LP_3$ are detected at three sampling moments $P_1$, $P_2$ and $P_3$, respectively, subsequent to the sampling moment of the peak X. If any of these levels $LP_1$, $LP_2$ and $LP_3$ were smaller than the level $L_x$, the peak X could be determined to be the expected peak. However, in the example shown in Figure 10, it is found that $L_x > LP_1$ but $L_x < LP_2$ and $L_x < LP_3$. Thus, a judgement is made that the peak X does not correspond periodically to the first peak WP0.

When the peak check is held affirmative in the step 245, the next step 246 is undertaken to set limit values to be used in a third procedure for cheking a third peak. The limit values are set as indicated in the following Table:

TABLE

| pitch between WP1 and WP0 | check time interval U | skip time interval V |
|---|---|---|
| more than 48 | 106 | 40 |
| 26 - 48 | 64 | 20 |
| less than 26 | 32 | 16 |

Namely, the detected pitch value BW = $t_1 - t_0$ between the adjacent peaks WP1 and WP0 is utilised to determine the check time interval U in which the pitch detection is undertaken for finding a third peak after the second peak WP1 and the skip time interval V in which the sample data is ignored after the occurrence of the peak WP1.

The above listed values are indicated as an example only. These values may be suitably set, but have to be based on the pitch between the peaks WP1 and WP0. In the next step 247, a flag B is set to the value 1 to indicate that the peak WP1 is detected.

9

If the peak check results in a NO at the step 245, processing proceeds to step 248 in which a judgement is effected as to whether the final moment ($t_0$ + 106) of the check time interval has passed. If the final moment is not reached, processing returns to the step 244 to undertake detection of a peak again. After repeatedly continuing the steps 244 and 245, if the objective peak is not finally detected, the judgement becomes YES in the step 248. Then, the flag B is cleared in step 249 and processing proceeds to step 217 of Figure 6.

Returning to Figure 6, a judgement is made in the step 217 as to whether the flag B is set to the value 1. When the flag B is zero, processing goes to the step 214 in which the failure of pitch detection is acknowledged. Then, the execution of the program is terminated.

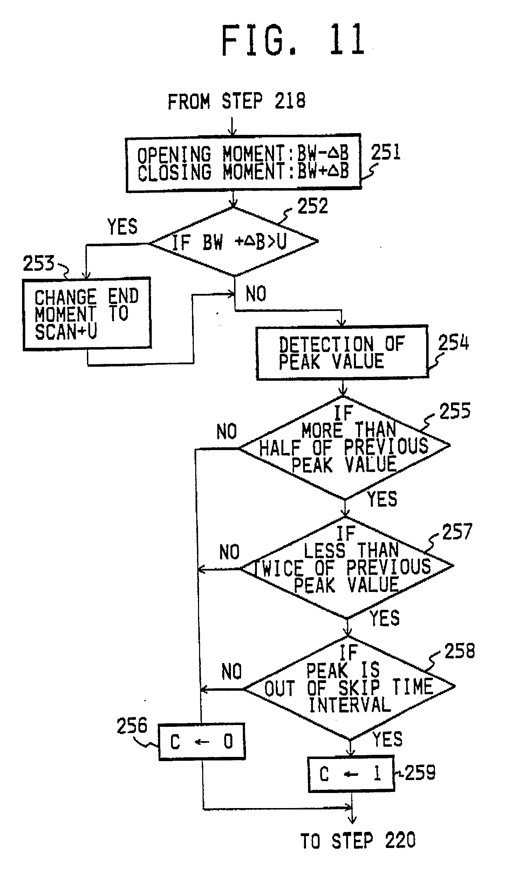

On the other hand, when B = 1, step 218 is carried out to set the detection reference point SCAN to WP1 for detecting a next third peak. Thereafter, processing proceeds to step 219 in which a third procedure according to the flow chart shown in Figure 11 is carried out for next peak detection.

Referring to the flow chart of Figure 11, a window time slot is set in step 251 between an opening moment BW - $\Delta$B and a closing moment BW + $\Delta$B for finding a next thrid peak WP2. In this instance, as shown in Figure 7, the value BW is set to be identical to the pitch between WP0 and WP1 or $t_1$ - $t_0$, and the window time slot ± $\Delta$B is determined according to the value of BW.

In step 252, judgement is made as to whether the closing moment BW + $\Delta$B is outside the check time interval U which is set in the step 246 of Figure 9. If BW + $\Delta$B > U, the closing moment is shifted to a time SCAN + U in step 253. If BW + $\Delta$B ≤ B = U, processing proceeds to step 254 without changing the set closing moment.

In the step 254, a maximum data sample is detected within the window time slot between the opening and closing moments to determine a third peak WP2. Then, the step 255 is undertaken to check if the level of the peak WP2 is more than half of the level of the peak WP1. When the result is NO, the detected peak WP2 is found to be false. Then, a flag C is cleared in step 256 to indicate the failure of the peak detection.

On the other hand, when the check result is YES in the step 255, a further judgement is made in step 257 as to whether the level of the peak WP2 is less than twice the level of the peak WP1. When the judgement is NO in the step 257, the detected peak WP2 is found to be false or inappropriate due to level abnormality and again the flag C is cleared in step 256. When the judgement is YES in the step 257, a further judgement is carried out in step 258 as to whether the sampling moment of the detected peak WP2 is outside the skip time slot $t_1$ + V. When the judgement is NO in the step 258, the processing once again proceeds to the step 256. When the judgement is YES, the detected peak WP2 is confirmed to be true and the flag C is set in step 259 to indicate that the third peak WP2 is properly detected within the window time slot.

Namely, in the third procedure, based on the data from the peaks WP0 and WP1, the window time slot ± B is set in the step 251 under the assumption that the third peak WP2 will be found at a pitch period substantially indentical with the pitch interval BW between the peaks WP0 and WP1. The maximum sampling point within the window time slot is assumed to be the peak WP2. Judgement is made as to whether the assumed peak WP2 is a true one by checking if the level of the assumed peak is within an expected range, for example between one half of the level of the peak WP1 and twice the level of the peak WP1, in the steps 255 and 257 so as to confirm the peak WP2.

Returning to Figure 6, step 220 is undertaken to check if the flag C = 1. When C = 1, the detection reference point SCAN is up-dated to WP2 in step 221. Then, step 222 is undertaken in a manner similar to the step 219 to detect a next fourth peak WP3.

In step 223, a judgement is carried out as to whether the peak WP3 is duly detected. When the judgement is YES, a confirmed peak period of the speech signal is calculated based on the data from the peaks WP0, WP1, WP2 and WP3 and the calculated result is output to terminate the program.

On the other hand, when failure of the peak detection is acknowledged in either of the steps 219 or 222, the judgement is NO in the steps 220 or 223 and processing proceeds to step 225. In the step 225, the level of the peak WP1, i.e. (WP1), is compared with the level of the peak WP0, i.e. (WP0). When (WP1) > (WP0) is confirmed in the step 226, processing proceeds to the step 214 to confirm the failure of the pitch detection.

On the other hand, when (WP1) ≤ (WP0), processing proceeds to step 227 to increment the value LOOPNB of the loop counter by the number 1, and a judgement is made in step 228 as to whether LOOPNB = 4. When LOOPNB ≠ 4, processing returns to the step 216 to repeat execution of the program. While re-executing the program, if the peak still cannot be detected so that LOOPNB reaches the value 4, the processing proceeds to the step 214 to confirm the failure of the pitch detection and thereby terminate execution of the program.

According to the invention as described with reference to Figure 8, the first sampling moment $t_0$ is

determined within a pre-determined time interval by detecting the first maximum peak WP0. Based on the level of the maximum peak, the blank time slot is determined to find the next second peak WP1 outside the blank time slot. Then, based on the pitch BW = | $t_1$ -$t_0$ |, the judgement is made as to whether the subsequent third and fourth peaks WP2 and WP3 are detected within the respective window time slots so as to confirm the pitch period. Therefore, the periodic nature of the speech signal and the pitch period can be quickly and accurately found.

A modified method of detecting the pitch period of a periodic part in a speech signal comprises a first step of detecting a first timing at which the speech signal has a first peak of a maximum peak level within a pre-determined time interval, a second step of determining according to the maximum peak level a level check starting moment for use in the detection of a second peak, a third step of detecting a second peak which occurs initially after the level check starting moment, a fourth step of detecting a level change in the vicinity of the second peak to determine whether the second peak corresponds periodically with the first peak, a fifth step of carrying out the third and fourth steps repeatedly to fix a second timing at which the second peak corresponding periodically to the first peak occurs, a sixth step of detecting within a window time slot predicted according to a time interval between the first and second timings a third timing at which a corresponding third peak occurs, and a seventh step of determining the pitch period according to the first, second and third timings.

After the first timing $t_0$ is detected in the first step, then when the second peak corresponding with the first peak is detected by means of the third step at the second timing $t_1$ the pitch period is assumed to be $t_1$ - $t_0$. Then, the timing of occurrence of a subsequent peak can be relatively accurately predicted according to the assumed pitch period $t_1$ - $t_0$. Based on such prediction, therefore, a predictive window time slot is set to check if a subsequent peak is detected so as to confirm the correctness of the assumed pitch period $t_1$ - $t_0$.

According to the above modified method and with reference to Figure 8, firstly speech signal processing is carried out to detect a first sampling moment $t_0$ at which the speech signal has a first peak of the maximum peak level within a pre-determined time interval. Then, the processing proceeds to detection of a second peak after the speech signal falls below a half of the maximum peak level and recovers beyond half of the maximum peak level. Then, in step 234, the level check is undertaken to detect the second peak, and judgement is made as to whether the detected second peak corresponds periodically to the first peak based on the level variation in the vicinity of the detected peak.

Based on the thus detected peak WP1, a pitch period BW is assumed to be WP1 - WP0 or $t_1$ - $t_0$. Within the window time slot BW ± $\Delta$B defined according to the assumed pitch period the subsequent third peak WP2 is searched and found. The correctness of the assumed pitch is confirmed when the condition WP1 - WP0 ≒ WP2 -WP1 is held, thereby detecting quickly and accurately the periodic nature and the pitch period of a speech signal.

As described above, according to a third aspect of the present invention, periodic nature and pitch period of a speech signal can be quickly and accurately detected with simplified signal processing.

Coding of periodic part

The method of coding a speech signal, as mentioned, involves the steps of dividing the speech signal into a non-periodic part and a periodic part, coding the non-periodic part directly according to ADPCM, and coding a frequency spectrum of each pitch segment of the periodic part according to ADPCM. The step of coding the periodic part comprises coding a first pitch segment of the periodic part directly on the time axis basis according to ADPCM, effecting Fourier Transformation of the coded first pitch segment to produce first spectrum data, processing second and subsequent pitch segments by effecting Fourier Transformation thereof to produce corresponding spectrum data in order to calculate differential spectrum data for the second and subsequent pitch segments using the first spectrum data as initial spectrum data in the differential calculation, and coding the differential spectrum data according to ADPCM.

When a periodic part is detected in the speech signal, a first pitch segment of the signal waveform is coded as it is according to ADPCM. Each subsequent pitch segment is converted into corresponding frequency spectrum data. Then, the differential calculation is undertaken for the second and subsequent spectrum data with reference to the first pitch segment to obtain respective differential data for each subsequent pitch segment. Each item of differential data is coded according to ADPCM. As a result, the periodic part can be coded pitch by pitch. When carrying out de-coding, the first pitch segment is reproduced on the time axis basis and then is utilised to de-code the coded data of the second and subsequent pitch segments.

The coding of a periodic part is described below in detail with reference to Figures 1, 2 and 3, which have been discussed generally already. Thus, the description below is directed specifically to the coding so as to avoid duplication.

Referring to Figure 2, after passing time $t_6$ as shown in Figure 3, some vowel is being uttered so that a pitch period $T_1$ is detected in the step 19 whereby processing proceeds to the step 22. In this step, the ADPCM coding is carried out for a first pitch slot $a_1$ in the waveform during the detected pitch period $T_1$ to produce corresponding code data $D_{41}$ which is stored in the RAM 8, and then the processing proceeds to the step 23. In this step 23, a first waveform segment of the speech signal S within the first pitch slot $a_1$ is subjected to Fourier Transformation, and its spectrum data $SP(a_1)$ is computed in the step 24. Then, the coding mode data MODE is set to PT in the step 25, and thereafter processing returns to the step 12.

Consequently, the judgement changes to YES in the step 12 so that coding of the speech signal is carried out according to the PT coding mode after the first pitch slot $a_1$ for the second and subsequent pitch slots.

Firstly, in the step 26, signal processing is undertaken to determine the second pitch slot $a_2$ and to code the second waveform segment within the second pitch slot $a_2$. The determination of the second slot $a_2$ is effected such that a third peak is searched in a window time slot $t_7 + T_1 \pm \Delta T$ which is set according to the pitch $T_1$ detected in the preceding steps and which is set with respect to the starting moment $t = t_7$. The third peak is detected at a sampling moment $t_8$ so that the second pitch slot $a_2$ is established between the moments $t_7$ and $t_8$. The waveform segment within the second pitch slot $a_2$ is subjected to Fourier Transformation to calculate frequency spectrum data $SP(a_2)$ for the second pitch slot. Then, differential data is calculated for the spectrum data $sp(a_2)$ with respect to the frequency spectrum data $SP(a_1)$, which has been calculated in the step 24 for the first pitch slot $a_1$. Namely, the differential data indicates spectrum difference of the succeeding spectrum data $SP(a_2)$ relative to the preceding spectrum data $SP(a_1)$. This differential data is coded according to ADPCM to output digital code data $D_{42}$ for the second pitch slot $a_2$, which is stored in the RAM 8.

Then, the signal processing proceeds to the step 27 to effect the determination of the next pitch slot as in a similar manner. When a fourth corresponding peak is detected in the step 27, the judgement is YES and processing returns to the step 26 in which the waveform segment in the pitch slot $a_3$ is coded in a manner similar to the preceding pitch slot $a_2$.

The steps 26 and 27 are thus repeatedly carried out so that every time a subsequent peak is detected based on the pitch period $T_1$, the ADPCM coding of the Fourier Transform data is effected to output subsequently digital code data $D_{43}, ..., D_{4n}$.

The non-periodic part of the speech signal is coded directly according to ADPCM. On the other hand, in the periodic part during which some vowel may be uttered, a pitch is detected and each waveform segment in each pitch period is subjected to Fourier Transformation to produce corresponding spectrum data. The respective spectrum data is then processed and coded according to ADPCM. In this processing, succeeding spectrum data is compared with preceding spectrum data and the differential data is coded according to ADPCM so as to achieve further data compaction.

As described above, according to a fourth aspect of the present invention, in coding the periodic part of a speech signal, the first pitch segment of the speech signal waveform is coded directly according to ADPCM on the time axis basis, thereby enabling further data compaction as compared to the prior art.

A modified method of coding a speech signal having the steps of dividing the speech signal into a non-periodic part and a periodic part, coding the non-periodic part directly according to ADPCM, and coding frequency spectrum data of each pitch segment of the periodic part according to ADPCM, comprises the steps of detecting a time duration of an utterance part of the speech signal, which follows the periodic part, and coding the utterance part in the same manner as the coding of a pitch segment of the periodic part when the time duration of the utterance part is shorter than the pitch period of the periodic part.

Judgement is made as to whether the time duration of an utterance part which follows the periodic part of the speech signal is shorter than one pitch period of the periodic part. If it is shorter, that utterance part is coded in a manner identical to the coding of each pitch segment of the periodic part. If it is longer than one pitch period, that utterance part is coded according to another coding mode which is applied to a non-periodic part of the speech signal.

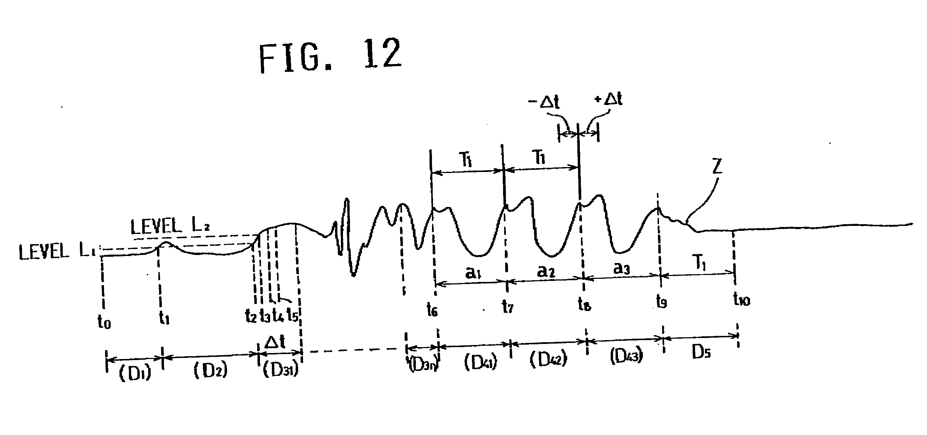

Hereinafter, a detailed description of this modified method is given in conjunction with Figures 1, 2 and 12. In this modified method, a speech signal S having a waveform shown in Figure 12 is processed by the Figure 1 apparatus according the Figure 2 program. Thus, duplicate description is omitted.

In the Figure 12 waveform, the third pitch slot $a_3$ is followed by a non-periodic part of the waveform, so that the judgement is NO in the step 27 of Figure 2 and processing proceeds to the step 28.

In the step 28, checking is carried out as to whether the level of the speech signal S is below a pre-determined level at the time $t = t_9 + T_1 + t_{10}$ so as to judge whether a silence part is following. When the level or amplitude of the speech signal S is below the pre-determined level at the time $t_{10}$, the judgement in the step 28 is YES and processing proceeds to the step 29. In this step, the digital coding is carried out according to the PT coding mode for the time slot $t_9$ to $t_{10}$ to produce last code data $D_5$ which is stored in the RAM 8. Then, the coding mode data MODE is set to 0 in the step 30 and processing returns to the step 12.

On the other hand, when the judgement in the step 28 is that the utterance part continues longer than one pitch period, processing proceeds to the step 31 in which the mode data MODE is set to AD and then returns to the step 12.

In the Figure 12 waveform, the sample data level of the speech signal S is zero at the sampling moment $t_{10}$. Therefore, the last pitch segment in the last pitch slot $t_9 - t_8$ is followed by the utterance part Z which is shorter than the pitch period $T_1$. Therefore, in this case, the judgement is YES in the step 28 so that the PFFT coding is effected in the step 29 for the short utterance part Z.

Consequently, since mode switching is not needed for the short and minor utterance part Z, discontinuation in the coding of the signal S can effectively be avoided. Further, the utterance part Z can be coded with the efficient PFFT coding to thereby improve the overall data compaction rate.

According to the invention, as described above, when a short utterance part follows the periodic part, the short utterance part is treated like a portion of the periodic part so as to effect high quality coding.

Another modified method of coding a speech signal having the steps of dividing the speech signal to be coded into a non-periodic part and a periodic part, coding the non-periodic part directly according to ADPCM, and coding frequency spectrum data of each pitch segment of the periodic part according to ADPCM, comprises the steps of detecting an utterance part which occurs subsequent to the last pitch segment of the periodic part, effecting Fourier Transformation of a waveform of the last pitch segment to produce corresponding frequency spectrum data, de-coding the frequency spectrum data to produce initial data, and coding the utterance part according to ADPCM using the initial data.

Digital data is effected according to ADPCM for a non-periodic part which follows a periodic part. In such a case, the last pitch segment of the speech signal waveform of the periodic part is converted through Fourier Transformation into corresponding frequency spectrum data. Then, the frequency spectrum data is converted on a time axis basis. Lastly, the non-periodic part is coded according to ADPCM utilising this converted time basis data as initial data. Therefore, when de-coding the coded data of the speech signal, the data reproduced for the last pitch segment of the periodic part is identical with the initial data as described above. Thus, when de-coding the ADPCM coded non-periodic part, the reproduced data of the last pitch waveform segment of the periodic part is utilised to achieve accurate and natural reproduction of the non-periodic part.

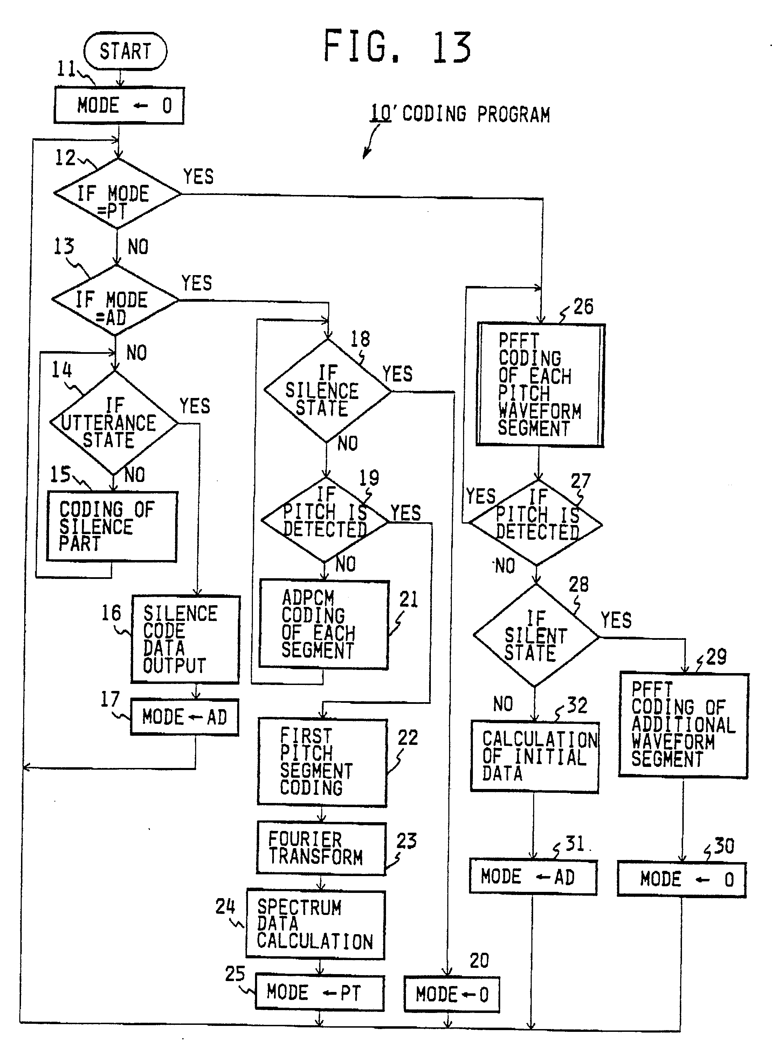

Hereinafter, a detailed description of this other modified method is given in conjunction with Figures 1, 3 and 13. In this modified method, a program represented by a flow chart shown in Figure 13 is substituted for the Figure 2 program. The same steps have identical numbering in both programs.

In the Figure 3 waveform, the third pitch slot $a_3$ is followed by a non-periodic part of the waveform, so that the judgement is NO in the step 27 of Figure 13 at this time and processing proceeds to the step 28.

In the step 28, checking is carried out as to whether the level of the speech signal S is below a pre-determined level at the time $t = t_9 + T_1 = t_{10}$ so as to judge if a silence part follows. When the level or amplitude of the speech signal S is below the pre-determined level at the time $t_{10}$, the judgement is YES and processing proceeds to the step 29. In this step, the digital coding is carried out according to the PT coding mode for the time slot $t_9$ to $t_{10}$ to produce last code data $D_5$ which is stored in the RAM 8. Then, the coding mode data MODE is set to 0 in the step 30 and processing returns to the step 12.

On the other hand, when a non-periodic part follows the periodic part beyond the sampling moment $t_{10}$, the judgement in the step 28 is that the utterance part continues and processing proceeds to an added step 32, in which the initial data is calculated. This initial data is utilised to code the non-periodic part after the moment $t_9$ according to ADPCM and is calculated as follows:

Firstly, Fourier Transformation is effected for the last pitch waveform segment in the last pitch slot $a_3$ to thereby convert the waveform segment of the pitch slot $a_3$ into, corresponding frequency spectrum data. This frequency spectrum data is identical to that produced in the preceding step 26, and, therefore, the data obtained in the step 26 may preferably be utilised as it is.

This frequency spectrum data is de-coded in the step 32 to time basis data $D_{in}$. The thus obtained time basis data $D_{in}$ is set in the RAM 8 as initial data for use in ADPCM coding of the speech signal after the sampling moment $t_9$. Thereafter, the mode data MODE is set to AD in the step 31 and processing returns to the step 12.

In the Figure 3 waveform, since the sample data level is not zero at the sampling moment $t_{10}$ and therefore a non-periodic part follows immediately after the last pitch slot $a_3$, the steps 32 and 31 are carried out before proceeding to the step 18 through the steps 12 and 13.

As discussed above, the judgement is NO in the steps 18 and 19, respectively, so that ADPCM coding is carried out for the non-periodic part in the step 21 utilising the initial data $D_{in}$ calculated in the step 32 and set in the RAM 8.

Digital coding is thus effected according to ADPCM for a non-periodic part which follows a periodic part. In such a case, the last pitch segment of the speech signal waveform of the periodic part is converted by Fourier Transformation into corresponding frequency spectrum data. Then, the frequency spectrum data is converted on the time axis basis. Lastly, the non-periodic part is coded according to ADPCM utilising this converted time basis data as initial data.

Therefore, when de-coding the coded data of the speech signal, the data reproduced for the last pitch waveform segment of the periodic part is identical to the initial data as described above Thus, when decoding the ADPCM coded non-periodic part, the data reproduced for the last pitch waveform segment of the periodic part is utilised to achieve accurate and natural reproduction of the non-periodic part.


## Claims

1. A method of coding a speech signal employing adaptive differential pulse code modulation, characterised by the steps of coding a non-periodic part of the speech signal by the adaptive differential pulse code modulation, effecting a Fourier transform for a periodic part of the speech signal in synchronisation with a pitch period of the periodic part to produce spectrum data, and coding the periodic part based on the spectrum data.

2. A method according to claim 1 characterised by the step of determining timing when a state of silence in the speech signal switches to a state of utterance.

3. A method according to claim 2 characterised in that the determining step comprises a first step of detecting when the amplitude of the speech signal exceeds a first pre-determined reference level, a second step of detecting when the amplitude of the speech signal exceeds a second pre-determined reference level which is set to be greater than the first reference level, and a third step of responding to the detection results in the first and second steps by assuming that the state of utterance has occurred from the timing at which the amplitude exceeded the first reference level when the amplitude exceeds the second reference level within a pre-determined time interval from that timing.

4. A method according to any preceding claim characterised by the step of detecting the pitch period of the periodic part of the speech signal.

5. A method according to claim 4 characterised in that the pitch period detecting step comprises a first step of detecting a first timing when the amplitude of the speech signal reaches a maximum peak value within a given time interval, a second step of setting a blank time slot according to the maximum peak value, a third step of detecting a second timing when the amplitude of the speech signal reaches another maximum peak value within another given time interval after passage of the blank time slot, and a fourth step of checking whether a time duration between the first and second timings appropriately indicates the pitch period of the speech signal.

6. A method according to claim 4 characterised in that the pitch period detecting step comprises a first step of detecting a first timing at which the speech signal has a first peak of a maximum peak level within a pre-determined time interval, a second step of determining according to the maximum peak level a level check starting moment for use in detection of a second peak, a third step of detecting a second peak initially occurring after the level check starting moment, a fourth step of detecting a level change in the vicinity of the second peak to determine whether the second peak corresponds periodically to the first peak, a fifth step of carrying out the third and fourth steps repeatedly to fix a second timing at which the second peak periodically corresponding to the first peak occurs, a sixth step of detecting within a window time slot predicted according to a time interval between the first and second timings a third timing at which a corresponding third peak occurs, and a seventh step of determining the pitch period according to the first, the second and the third timings.

7. A method according to any preceding claim characterised in that the step of coding the periodic part comprises coding a first pitch segment of the periodic part directly on a time axis basis according to adaptive differential pulse code modulation, effecting the Fourier transform for the coded first pitch segment to produce first spectrum data, processing second and subsequent pitch segments to effect the Fourier transform therefor to produce corresponding spectrum data so as to calculate differential spectrum data for the second and subsequent pitch segments using the first spectrum data as initial spectrum data in the differential calculation, and coding the differential spectrum data according to adaptive differential pulse code modulation.

8. A method according to any preceding claim characterised by the steps of detecting a time duration of an utterance part of the speech signal, which follows the periodic part, and coding the utterance part in a same manner as coding a pitch segment of the periodic part when the time duration of the utterance part is shorter than the pitch period of the periodic part.

9. A method according to any of claims 1 to 7 characterised by the steps of coding frequency spectrum data for pitch segments of the periodic part according to adaptive differential pulse code modulation, detecting an utterance part which occurs subsequent to the last pitch segment of the periodic part, effecting the Fourier transform for the last pitch segment to produce corresponding frequency spectrum data, decoding the frequency spectrum data to produce initial data, and coding the utterance part according adaptive differential pulse code modulation using the initial data.

10. A method of coding a speech signal having a periodic part and a non-periodic part, comprising the steps of: coding the non-periodic part by adaptive differential pulse code modulation; effecting Fourier transform of the periodic part in synchronisation with a pitch period of the periodic part to produce spectrum data thereof; and coding the periodic part based on the spectrum data.

# FIG. 1

# FIG. 2

10 CODING PROGRAM

11 → MODE ← 0

12 IF MODE =PT — YES

NO

13 IF MODE =AD — YES

NO

14 IF UTTERANCE STATE — YES

NO

15 CODING OF SILENCE PART

16 OUTPUT OF CODED SILENCE DATA

17 MODE ← AD

18 IF SILENCE STATE — YES

NO

19 IF PITCH IS DETECTED — YES

NO

21 ADPCM CODING FOR EACH TIME SLOT

22 ADPCM CODING FOR INITIAL PITCH SLOT

23 FOURIER TRANSFER

24 COMPUTATION OF SPECTRUM DATA

25 MODE ← PT

20 MODE ← 0

26 PFFT CODING FOR EACH PITCH SLOT

27 IF PITCH IS DETECTED — YES

NO

28 IF SILENCE STATE — YES

NO

31 MODE ← AD

29 PFFT CODING FOR ADDITIONAL SLOT

30 MODE ← 0

FIG. 3

# FIG. 4

<u>100</u> SIGNAL PROCESSING PROGRAM

# FIG.5

# FIG. 6

```
                        START
211 ──  SCAN ← 0
                                            200
212 ──  FIRST
        PROCEDURE
213 ──  IF F=1  ──NO──────────────────┐
          │YES                        │
215 ──  SCAN ← WPO                     │
        LOOPNB ← 0                     │
          │                           │
          ├──────────────┐            │
216 ──  SECOND           │            │
        PROCEDURE         │            │
          │              │            │
217 ──  IF B=1  ──NO──────────────────┤
          │YES           │            │
218 ──  SCAN ← WP1        │            │
          │              │            │
219 ──  THIRD            │            │
        PROCEDURE         │            │
          │              │            │
220 ──  IF C=1  ──NO──┐   │            │
          │YES        │   │            │
221 ──  SCAN ← WP2    │   │   (WP1)>(WPO)CHECK  225
          │           │   │         │
222 ──  PEAK          │   │  226 ──  >  ──YES──┤
        DETECTION      │   │         │NO       │
          │           │   │   LOOPNB + 1  227  │
223 ──  SETTING ──NO───┘   │         │         │
          │YES            │  228 ──  IF        │
224 ──  DATA             │   LOOPNB ──YES──────┤
        OUTPUT            │   =4              FAILURE  214
          │              │         │NO
          │              └─────────┘
          │
         END
```

EP 0 385 799 A2

## FIG.7

## FIG. 8

# FIG. 9

FROM STEP 215

START MOMENT:SCAN+16
END MOMENT:WPO+106 — 241

CONFIRMATION OF LEVEL
FALLING BELOW(WPO)/2 — 242

CONFIRMATION OF LEVEL
RISING OVER(WPO)/2 — 243

DETECTION OF PEAK — 244

IF PEAK CHECK OK — 245 — YES

SETTING OF LIMIT VALUE — 246

NO

IF END TIME OVER — 248 — NO

B ← 1 — 247

YES

B ← 0 — 249

TO STEP 217

# FIG. 10

X

L₁

LP₃

LP₂

LP₁

P₁ P₂ P₃

# FIG. 11

FROM STEP 218

OPENING MOMENT:BW−ΔB
CLOSING MOMENT:BW+ΔB          251

252

IF BW +ΔB>U

YES

253
CHANGE END
MOMENT TO
SCAN+U

NO

DETECTION OF
PEAK VALUE          254

255
IF
MORE THAN
HALF OF PREVIOUS
PEAK VALUE

NO

YES

257
IF
LESS THAN
TWICE OF PREVIOUS
PEAK VALUE

NO

YES

258
IF
PEAK IS
OUT OF SKIP TIME
INTERVAL

NO

YES

256
C ← 0

C ← 1   259

TO STEP 220

# FIG. 12

EP 0 385 799 A2

# FIG. 13

10' CODING PROGRAM